# EUROPÄISCHE PATENTSCHRIFT

(11) **EP 0 877 543 B1**
(45) Veröffentlichungstag und Bekanntmachung des Hinweises auf die Patenterteilung: **19.09.2001**
(21) Anmeldenummer: 98810164.8
(22) Anmeldetag: 27.02.1998
(51) Int. Cl.: H05K 9/00

(54) **Baugruppenträger mit Abdeckblechen**
Electronic component with shielding sheets
Composant électronique avec tôles de blindage

(30) Priorität: 29.04.1997 DE 29707756 U
(43) Veröffentlichungstag der Anmeldung: 11.11.1998
(73) Patentinhaber: ELMA Electronic AG, 8620 Wetzikon (CH)
(72) Erfinder: Mangold, Urs, 8331 Auslikon (CH)
(74) Vertreter: Sulzer Management AG

(56) Entgegenhaltungen:
- EP-A- 0 727 853
- DE-U- 29 502 404

## Beschreibung

Die Erfindung handelt von einem Baugruppenträger mit Abdeckblechen, von denen zwei Abdeckbleche eine Winkelverbindung bilden, wobei in einem ersten Blech parallel zu dessen Kante bandförmige Durchrisse herausgeformt sind und zum Blech Ösen bilden, in die Zungen von einem abgebogenen Winkelstück von einem zweiten Blech einsteckbar sind.

Baugruppenträger für elektrische und elektronische Komponenten sind beispielsweise in den Normen der IEC Standards für die Gehäuse und Bauteile der 19-Zoll-Technik definiert und verschiedene Hersteller bieten Baugruppenträger in dieser Technik an. So zeigt ein Prospekt der Firma Knürr AG, Schatzbogen 29, D-81829 München, 19"-Baugruppenträger/VME-System im Katalog 1997, deren Deckelblech abgebogen ist und mit einzelnen Zungen in nach aussen vorstehenden, bandförmigen Durchrissen von Seitenteilen eingesteckt ist. Andere Zungen des abgebogenen Winkelstücks sind mit den Seitenteilen durch Schrauben verbunden. Diese Verbindung hat den Nachteil, dass zeitlich unbegrenzte und für eine Abschirmung notwendige Kontaktkräfte mit Sicherheit an den Verschraubungen auftreten, während mit den eingesteckten Zungen zwar eine gute Primärverankerung und eine gute Primärkontaktierung erreicht wird, eine Langzeitkontaktierung aber nicht so sicher ist. Ein weiterer Nachteil sind die gegenüber der Ebene des Seitenblechs vorstehenden Konturen von Winkelstück, Zungen, Schraubenköpfen und Durchrissen, die Angriffspunkte gegenüber harten Gegenständen bilden.

Aufgabe der Erfindung ist es, eine kraftschlüssige, wiederholt steckbare Verbindung zwischen einem Winkelstück und einem Blech zu schaffen.

Diese Aufgabe wird mit den Kennzeichen vom unabhängigen Anspruch 1 dadurch gelöst, dass das Winkelstück und die Ösen auf der Innenseite des Baugruppenträgers angeordnet sind und dass am Winkelstück Kontaktfedern freigeschnitten sind, auf deren Aussenseite Noppen angebracht sind, welche im eingefahrenen Zustand eine vorgesehene Kontaktkraft erzeugen.

Vorteilhafte Weiterbildungen ergeben sich aus den Unteransprüchen 2 bis 9.

Die Anordnung hat den Vorteil, dass glatte Aussenflächen entstehen und dass durch die geschützte Anordnung Kontaktfedern gewählt werden können, die lang und elastisch genug sind, um unabhängig von Vibrationen und Erschütterungen dauernde Kontaktfläche zu erzeugen. Obwohl aus dem gleichen Blech geformt, sind Kontaktfedern mit langem Federweg möglich. Mit Noppen, die aus dem Blechmaterial herausgedrückt sind, kann der gleiche Werkstoff für den Kontakt gewählt werden, um das Risiko für Korrosion wegen unterschiedlicher Spannungspotentiale herabzusetzen. Wenn Kontaktfedern und Einsteckzungen räumlich nahe zusammengelegt werden, lassen sich das Prägen der Noppen, das Freischneiden der Kontaktfedern und das Freischneiden der Einsteckzungen in einem Werkzeug zusammenfassen und der Abstand 1 zwischen zwei Kontaktpunkten längs der Knickkante von einem Winkelstück ist entsprechend den Abschirmforderungen durch blosses Verschieben vom Werkstück frei wählbar. Falls zwischen Winkelstück und Abdeckblech grössere Biegemomente zu übertragen sind, können Ösen und Einsteckungen in wechselndem Abstand zur Knickkante vom Winkelstück angebracht werden und so im Schnitt gesehen über den Abstand der bandförmigen Durchrisse Biegemomente in beiden Richtungen aufnehmen. Wesentlich ist, dass der Nachfederweg der Kontaktfedern gross genug ist, um trotz Mikrobewegungen genügend grosse Kontaktkräfte zu erzeugen. Ein weiterer Vorteil ergibt sich, wenn die Noppen in der Nähe von den Einsteckungen angeordnet sind, weil die Toleranzen beim Einstecken durch einen vergleichsweise grossen Federweg der Kontaktfedern aufgefangen werden.

Im folgenden wird die Erfindung durch Beispiele beschrieben. Es zeigen in vergrösserter Form:
- Fig. 1: Schematisch eine Innenansicht auf ein erstes Blech, an dem ein zweites Blech über ein Winkelstück mit Einsteckungen und Kontaktfedern anliegt;
- Fig. 2: schematisch einen Längsschnitt durch Fig. 1;
- Fig. 3: schematisch eine Anordnung wie in Fig. 2, bei der zwei Winkelbleche mit dem ersten Abdeckblech verbunden sind;
- Fig. 4: schematisch eine Anordnung wie in Fig. 1, bei der die Noppen in die Nähe der Einsteckzungen gelegt wurden;
- Fig. 5: schematisch einen Längsschnitt durch Fig. 4;
- Fig. 6: schematisch eine Anordnung, bei der die Basis der Kontaktfedern quer zur Knickkante vom Winkelstück steht;
- Fig. 7: schematisch einen Querschnitt von Fig. 6 im Bereich von Einsteckzunge und Öse;
- Fig. 8: schematisch eine Anordnung nach Fig. 4, bei der zu einer ersten Reihe von Einsteckzungen und Ösen in einem Abstand zur Knickkante versetzt eine weitere Reihe von Einsteckzungen und Ösen angebracht wurde;
- Fig. 9: schematisch eine Anordnung analog zu Fig. 6, bei der die Federlänge der Kontaktfedern grösser als die Höhe vom Winkelstück ist;
- Fig. 10: schematisch und stark vergrössert einen Längsschnitt durch ein Winkelstück, bei dem die Kontaktfeder aus der Blechebene heraus nach innen verformt ist, während der Noppen durch die Blechebene hindurch nach aussen verformt ist; und
- Fig. 11: schematisch eine Seitenansicht von Fig. 10.

Mit den Figuren sind Baugruppenträger mit Abdeckblechen 1, 2, 3 gezeigt, von denen zwei Abdeckbleche eine Winkelverbindung bilden. In einem ersten Blech 1 sind auf einer Geraden bandförmige Durchrisse 14 herausgeformt, um Einsteckösen 5 zu bilden, in die Zungen 6 von einem abgebogenen Winkelstück 7 eingreifen. Am Winkelstück sind Kontaktfedern 8 freigeschnitten und auf deren Aussenseite Noppen als Kontaktpunkte vorstehend angebracht. Dadurch, dass die Einsteckösen 5, die Einsteckzungen 6 und die Kontaktfedern 8 geschützt auf der Innenseite 11 vom Gehäuse angeordnet sind, entstehen glatte Aussenflächen und können Kontaktfedern 8 mit einem langen Federweg gewählt werden.

Innerhalb der Figuren sind gleiche Bezugszeichen beibehalten.

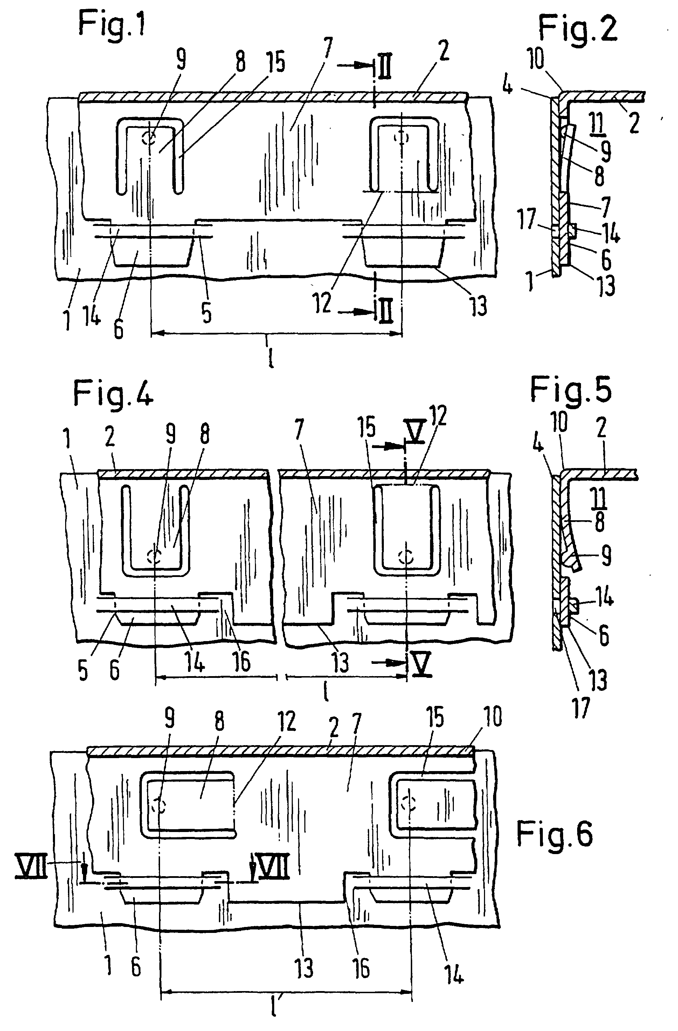

In Fig. 1 und 2 sind ein erstes Abdeckblech 1 und ein zweites Abdeckblech 2, das zu einem Winkelstück 7 abgebogen ist, über eine auf der Innenseite 11 vom Baugruppenträger liegende Steckverbindung verbunden. Ein bandförmiger Durchriss 14 lässt einen Schlitz 17 stehen und erzeugt eine Öse 5, in die eine Zunge 6 vom Winkelstück 7 eingesteckt ist. Die Zungen 6 stehen mit ihrer Kante 13 über die Durchrisse 14 hinaus, um auch begrenzt Biegekräfte aufzunehmen. Mit einem Umformwerkzeug wurden Noppen 9 zur Aussenseite geformt und mit einem Freischnitt 15 Kontaktfedern 8 in einem wählbaren Abstand 1 erzeugt. Eine Basis 12 der Kontaktfedern 8 liegt parallel zur Knickkante 10 vom Winkelstück 7. Die Kontaktfedern 8 erstrecken sich von der Basis 12 weg entgegen einer Steckrichtung bei Montage, sodass ein Stauchen der Kontaktfedern 8 ausgeschlossen ist. Die Lage der Noppen 9 zu den Zungen 6 kann so gewählt werden, dass die Zungen 6 in den Ösen 5 beim Einstecken greifen, bevor die Noppen 9 auf dem ersten Blech 1 auffahren.

In den Figuren 4 und 5 ist die Richtung der Kontaktfedern umgekehrt und entsprechend sanft ist der Anstieg der Kontaktnoppen 9 in Steckrichtung gestaltet, wobei eine Verrundung der Kante 4 vom ersten Abdeckblech ebenfalls mithilft. Die Anordnung hat dafür den Vorteil, dass der Kontakt und ein relativ langer Kontaktfederweg in der Nähe der Einsteckung 6 und der Einstecköse 5 liegen, wobei ganz allgemein der Federweg resp. die Höhe vom Noppen 9, mehr als das Vierfache vom möglichen Spiel zwischen Einstecköse 5 und Einsteckzunge 6 beträgt. Die Form der Einsteckzungen 6 wird hier durch Ausklinkungen 16 an der Kante 13 vorgenommen, wobei die Ausklinkungen 16 so gross gewählt sind, dass sie die vorspringenden Ösen bei der Montage frei lassen, aber trotzdem so klein in ihren Abmessungen sind, dass sie mit der Kontaktfeder 8 in einem Werkzeug für den Freischnitt 15 herstellbar sind. Der Abstand 1 zwischen den Kontaktfedern ist dann frei wählbar und nicht mehr werkzeuggebunden.

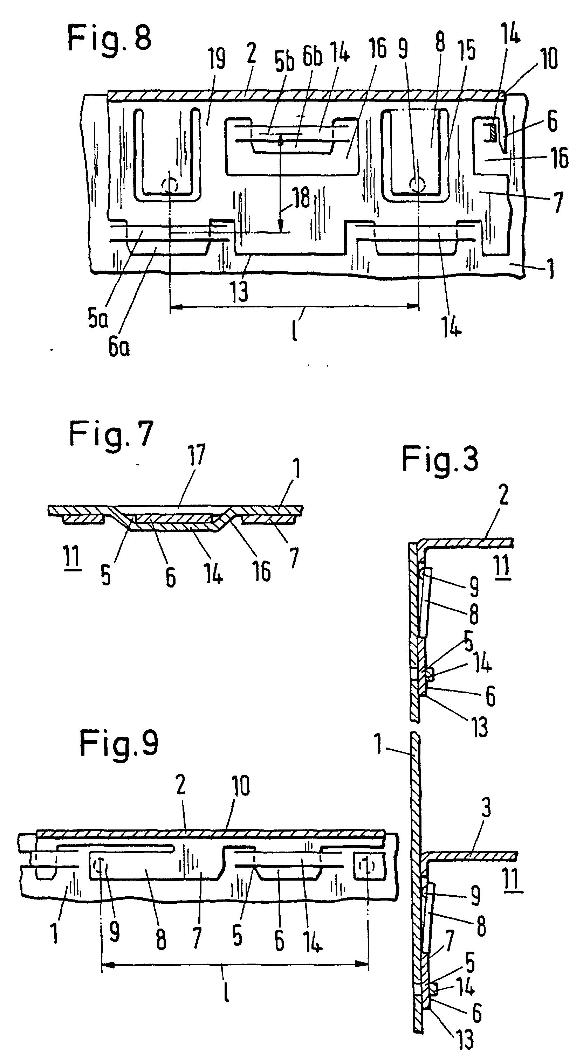

In den Figuren 6 und 7 sind die Kontaktfedern 8 mit ihrer Basis 12 quer zur Knickkante 10 vom Winkelstück 7 angeordnet. Die Länge der Kontaktfedern resp. vom Freischnitt 15 ist damit weniger von der Höhe vom Winkelstück 7 abhängig. Trotzdem ist die Länge 1 für den Abstand der Kontaktpunkte immer noch frei wählbar und könnte bis an ein Weglassen der Kante 13 zwischen zwei Ausklinkungen 16 verkleinert werden. Die restlichen Bezeichnungen stimmen mit den vorher beschriebenen Figuren überein.

Eine Weiterentwicklung vom Beispiel in Fig. 6 und 7 ist in der Fig. 9 gezeigt. Steckverbindungen mit Zunge 6 und Öse 5 lösen sich längs vom Winkelstück 7 praktisch im gleich kurzen Abstand von der Knickkante 10 mit Kontaktfedern 8 ab. Die Höhe vom Winkelstück 7 ist klein gehalten. Trotzdem kann die Kontaktfederlänge erheblich grösser als die Höhe vom Winkelstück 7 sein. Der Abstand 1 zwischen zwei Kontaktpunkten ist dafür nur bis auf die Summe vom minimalen Längenanteil der Kontaktfeder 8 und ihrer seitlichen Abstützung sowie vom minimalen Längenanteil für die Verbindung von Zunge 6 und Öse 5 kürzbar.

In Fig. 8 ist ein weiteres Beispiel gezeigt, bei dem die Zungen 6a, 6b sehr kurz gehalten werden können, weil sie auf zwei verschiedene Abstände zur Knickkante 10 vom Winkelstück 7 verteilt sind. Durch einen Abstand 18 zwischen den Zungen 6a, 6b und den dazugehörigen Ösen 5a, 5b können über das Winkelstück 7 Momente in beiden Richtungen übertragen werden. Voraussetzung für diese Verbindung ist, dass sich das erste Abdeckblech 1 mit seiner Öse 5b seitlich in die Aussparung 16 im Winkelstück 7 einrücken lässt, um das Einstecken der Zunge 6b zu ermöglichen. Auch bei diesem Beispiel ist der Abstand 1 der Kontaktpunkte von der Summe der Masse für Einstecken und für die Kontaktfeder abhängig, wobei Zwischenstege 19 für die Uebernahme der Kräfte von den Zungen 6a an der Kante 13 vom Winkelstück 7 notwendig sind.

In Fig. 3 ist durch die zweifache Wiederholung von Fig. 2 gezeigt, dass ein zweites Blech 3 mit einem Winkelstück 7 ebenso auch weiter innen im Gehäuse zum Herstellen einer T-Verbindung verwendet werden kann, wobei die Vorteile der Kontaktfedern 8 und der Art der Verbindung 5, 6 erhalten bleiben.

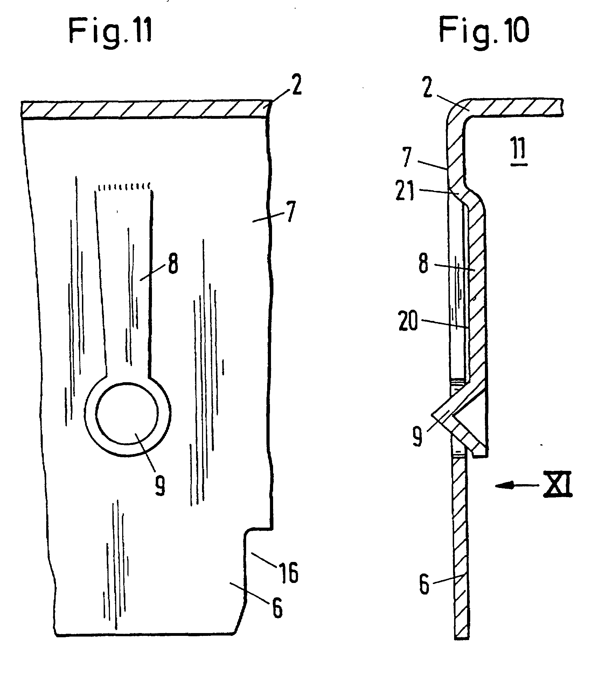

In Fig. 10 und Fig. 11 ist eine Kontaktfeder 8 gezeigt, die allgemein aus einem Blech 2, 7 herausgeformt werden kann, um eine am Blech anliegende Fläche zu kontaktieren.

Die Kontaktfeder 8 ist an ihrem Fuss in einer Stauchzone 21 soweit herausverformt, dass sie um ein Spiel 20 vom Blech entfernt ist, während ein konisch geformter Noppen 9 soweit in der Gegenrichtung herausgedrückt ist, dass er im unbelasteten Zustand die Blechebene durchstösst und auf der Gegenseite vorsteht. Ein Vorteil dieser Anordnung ist, dass die Kontaktfeder 8 nicht überlastet werden kann, da sie nur bis zum Verschwinden der Noppenspitze beansprucht wird. Ein weiterer Vorteil ist, dass die Kontaktfeder mit einem einzigen Umformwerkzeug herstellbar ist, bei dem ein Durchriss der Kontaktfeder das Freischneiden ersetzt. Ein weiterer Vorteil ist, dass die Kontaktfeder 8 mit ihrer Breitenveränderung vom Noppen zum Fuss hin dem Material des Blechs für eine vorgegebene Kontaktkraft angepasst werden kann. Bei weichen Aluminiumblechen hat sich als weiterer Vorteil erwiesen, dass durch die Stauchzone 21 eine Verfestigung eintritt, die in diesem Bereich die Elastizitätsgrenze heraufsetzt.

## Patentansprüche

1. Baugruppenträger mit Abdeckblechen (1, 2, 3), von denen zwei Abdeckbleche eine Winkelverbindung bilden, wobei in einem ersten Blech (1) parallel zu dessen Kante (4) bandförmige Durchrisse (14) herausgeformt sind und zum Blech (1) Ösen (5) bilden, in die Zungen (6) von einem abgebogenen Winkelstück (7) von einem zweiten Blech (2, 3) einsteckbar sind, **dadurch gekennzeichnet, dass** das Winkelstück (7) und die Ösen (5) auf der Innenseite (11) des Baugruppenträgers angeordnet sind und dass am Winkelstück (7) Kontaktfedern (8) freigeschnitten sind, auf deren Aussenseite Noppen (9) angebracht sind, welche im eingefahrenen Zustand eine vorgesehene Kontaktkraft erzeugen.

2. Baugruppenträger nach Anspruch 1, **dadurch gekennzeichnet, dass** die Zungen (6) unterhalb und in der Nähe der Kontaktfedern (8) angeordnet sind, damit beide zusammen mit einem Werkzeug herstellbar sind.

3. Baugruppenträger nach einem der Ansprüche 1 oder 2, **dadurch gekennzeichnet, dass** die Kontaktfeder (8) mit ihrer Basis (12) parallel zur Kante (13) vom Winkelstück ausgerichtet ist.

4. Baugruppenträger nach einem der Ansprüche 1 oder 2, **dadurch gekennzeichnet, dass** die Basis (12) der Kontaktfeder (8) quer zur Knickkante (10) vom Winkelstück (7) angeordnet ist.

5. Baugruppenträger nach einem der Ansprüche 1 bis 4, **dadurch gekennzeichnet, dass** die Noppen (9) mit einem Umformwerkzeug aus dem Blech herausgedrückt sind.

6. Baugruppenträger nach einem der Ansprüche 1 bis 5, **dadurch gekennzeichnet, dass** die Höhe der Noppen (9) kleiner ist als der maximal zulässige Federweg der Kontaktfedern (8) für elastische Verformung.

7. Baugruppenträger nach einem der Ansprüche 1 bis 6, **dadurch gekennzeichnet, dass** am Winkelstück (7) Zungen (6a, 6b) mit unterschiedlichen Abständen zur Knickkante (10) vom Winkelstück freigeschnitten sind und dass Ösen (5a, 5b) mit passenden unterschiedlichen Abständen im ersten Blech (1) ausgeformt sind.

8. Baugruppenträger nach einem der Ansprüche 1 bis 7, **dadurch gekennzeichnet, dass** die Kontaktfeder (8) im unbelasteten Zustand um ein Spiel (20) aus dem Winkelstück (7) nach innen (11) wegsteht, während nach aussen ein konischer Kontaktnoppen angeformt ist, der um einen vorgegebenen Deformationsweg nach aussen über das Winkelstück (7) vorsteht.

9. Baugruppenträger nach einem der Ansprüche 1 bis 8, **dadurch gekennzeichnet, dass** er in den Dimensionen der 19 Zoll Baugruppenträger ausgeführt ist.

## Claims

1. Module carrier with sheet metal covers (1, 2, 3), of which two sheet metal covers form an angle connection, with strip-like pierced webs (14) being formed in a first sheet metal part (1) parallel to its edge (4) and forming eyes (5) with respect to the sheet metal part (1) into which tongues (6) of a bent angled piece (7) of a second sheet metal part (2, 3) can be inserted, **characterised in that** the angled piece (7) and the eyes (5) are arranged on the inner side (11) of the module carrier; and in that contact springs (8) are cut free at the angled piece (7) and noses (9) are arranged on the outer side thereof which produce a predetermined contact force in the inserted state.

2. Module carrier in accordance with claim 1, **characterised in that** the tongues (6) are arranged beneath and in the vicinity of the contact springs (8) so that both can be manufactured together with one tool.

3. Module carrier in accordance with claim 1 or claim 2 **characterised in that** the contact spring (8) is oriented with its base (12) parallel to the edge (13) of the angled piece.

4. Module carrier in accordance with claim 1 or claim 2 **characterised in that** the base (12) of the contact spring (8) is arranged transverse to the bent edge (10) of the angled piece (7) .

5. Module carrier in accordance with any one of the claims 1 to 4 **characterised in that** the noses (9) are pressed out of the sheet metal part with a forming tool.

6. Module carrier in accordance with any one of the claims 1 to 5 **characterised in that** the height of the noses (9) is less than the maximum permissible spring travel of the contact springs (8) for elastic deformation.

7. Module carrier in accordance with any one of the claims 1 to 6 **characterised in that** tongues (6a, 6b) with different distances from the bent edge (10) of the angled piece (7) are cut free at the angled piece (7); and in that eyes (5a, 5b) with suitable different spacings are formed in the first sheet metal part (1) .

8. Module carrier in accordance with any one of the claims 1 to 7 **characterised in that** the contact spring (8) protrudes inwardly (11) from the angled piece (7) in the unstressed state by a clearance (20), whereas a conical contact nose is formed outwardly which projects outwardly beyond the angled piece (7) by a predetermined deformation path.

9. Module carrier in accordance with any one of the claims 1 to 8 **characterised in that** it is executed in the dimensions of the 19 inch module carrier.

## Revendications

1. Support de composant avec des tôles de blindage (1, 2, 3) dont deux tôles de blindage forment une liaison angulaire, où dans une première tôle (1) parallèlement au bord (4) de celle-ci, des ruptures en forme de bande (14) sont formées et constituent des oeillets (5) de la tôle (1) dans lesquels peuvent être insérées les languettes (6) d'une pièce angulaire repliée (7) d'une deuxième tôle (2,3), **caractérisé en ce que** la pièce angulaire (7) et les oeillets (5) sont disposés au côté intérieur (11) du support de composant et qu'à la pièce angulaire (7), des ressorts de contact (8) sont dégagés, sur le côté extérieur desquels sont disposés des tétons (9) qui, à l'état rentré, produisent une force de contact prévue.

2. Support de composant selon la revendication 1,
**caractérisé en ce que** les languettes (6) sont disposées en dessous et au voisinage des ressorts de contact (8) pour que les deux puissent être fabriqués ensemble avec un outil.

3. Support de composant selon l'une des revendications 1 ou 2, **caractérisé en ce que** le ressort de contact (8) est orienté avec sa base (12) parallèlement au bord (13) de la pièce angulaire.

4. Support de composant selon l'une des revendications 1 ou 2, **caractérisé en ce que** la base (12) du ressort de contact (8) est disposée transversalement à l'arête de pliage (10) de la pièce angulaire (7).

5. Support de composant selon l'une des revendications 1 à 4, **caractérisé en ce que** les tétons (9) sont poussés avec un outil de formage hors de la tôle.

6. Support de composant selon l'une des revendications 1 à 5, **caractérisé en ce que** la hauteur des tétons (9) est plus petite que l'allongement maximal admissible des ressorts de contact (8) pour une déformation élastique.

7. Support de composant selon l'une des revendications 1 à 6, **caractérisé en ce que** sont libérées par découpage à la pièce angulaire (7) des languettes (6a, 6b) à des écarts différents à l'arête de pliage (10) de la pièce angulaire, et que des oeillets (5a, 5b) avec des écarts différents adaptés, sont formés dans la première tôle (1).

8. Support de composant selon l'une des revendications 1 à 7, **caractérisé en ce que** le ressort de contact (8) à l'état non sollicité, s'écarte d'un jeu (20) de la pièce angulaire (7) vers l'intérieur (11) tandis qu'il est rapporté par formage vers l'extérieur un téton de contact conique qui fait saillie selon un trajet de déformation prédéfinie vers l'extérieur sur la pièce angulaire (7).

9. Support de composant selon l'une des revendications 1 à 8, **caractérisé en ce qu'**il est réalisé dans les dimensions des supports de composants de 19 pouces.
